# EUROPEAN PATENT APPLICATION

(11) **EP 2 214 463 A2**
(43) Date of publication of application: **04.08.2010**
(21) Application number: 10151087.3
(22) Date of filing: 19.01.2010
(51) Int. Cl.: H05K 7/14

(54) **Apparatus for isolating multiple circuit boards from vibration**

(30) Priority: 28.01.2009 US 361136
(71) Applicant: Honeywell International Inc., Morristown, NJ 07962 (US)
(72) Inventor: Armon, Lori, Morristown, NJ 07962-2245 (US); Goldman, Daniel, Morristown, NJ 07962-2245 (US); Boyd, Larren Elton, Morristown, NJ 07962-2245 (US)
(74) Representative: Buckley, Guy Julian

(57) **Abstract**

An apparatus for isolating an electronic device from vibration is provided. The apparatus includes a rigid frame and a circuit board assembly comprising a plurality of circuit boards. A first isolator is located on a first side of the circuit board assembly between the circuit board assembly and the rigid frame, wherein the first isolator is held in place by equal and opposite forces from the rigid frame and the circuit board. A second isolator is located on a second side of the circuit board assembly between the circuit board and the rigid frame. The second isolator is substantially opposite of the first isolator in relation to the circuit board assembly, wherein the second isolator is held in place by equal and opposite forces from the rigid frame and the circuit board. A third isolator is located on a third side of the circuit board assembly between the circuit board assembly and the rigid frame, wherein the third isolator is held in place by equal and opposite forces from the rigid frame and the circuit board. A fourth isolator is located on a fourth side of the circuit board assembly between the circuit board assembly and the rigid frame. The fourth isolator is substantially opposite of the third isolator in relation to the circuit board assembly, wherein the fourth isolator is held in place by equal and opposite forces from the rigid frame and the circuit board.

## Description

### BACKGROUND

Isolation of components from environmental vibration is important for devices that are sensitive to the vibration frequencies. For example, to obtain precise measurements, it is helpful to isolate the measurement devices from the source of the vibrations. Additionally, some sensitive devices with mechanical components may fail if vibration frequencies cause the mechanical components to resonate uncontrollably.

Conventional vibration isolation devices attach between a component to be isolated ("isolated component") and some other structure ("base structure") to which the isolated component is to be coupled. These isolation devices dampen harmful or unwanted vibration frequencies propagating through the base structure before the vibration is coupled to the isolated component. For example, in some applications metal rings or other rigid structures that connect the isolated component to the frame are molded with a soft material thereon to absorb vibrations traveling along the rigid components. The rigid components of these isolation devices are typically mounted to the isolation component and to the base structure by screws or bolts.

As industry continues to demand smaller overall package sizes for devices, isolation devices must become smaller as well. As devices become smaller, however, mounting locations for the isolation device on the isolated component become limited. Additionally, as devices become smaller, the mass of the isolated component may be reduced. This causes changes in the natural vibration frequency of the device and may be difficult to isolate with conventional isolators.

### SUMMARY

In one embodiment, an apparatus for isolating an electronic device from vibration is provided. The apparatus includes a rigid frame and a circuit board assembly comprising a plurality of circuit boards. A first isolator is located on a first side of the circuit board assembly between the circuit board assembly and the rigid frame, wherein the first isolator is held in place by equal and opposite forces from the rigid frame and the circuit board. A second isolator is located on a second side of the circuit board assembly between the circuit board and the rigid frame. The second isolator is substantially opposite of the first isolator in relation to the circuit board assembly, wherein the second isolator is held in place by equal and opposite forces from the rigid frame and the circuit board. A third isolator is located on a third side of the circuit board assembly between the circuit board assembly and the rigid frame, wherein the third isolator is held in place by equal and opposite forces from the rigid frame and the circuit board. A fourth isolator is located on a fourth side of the circuit board assembly between the circuit board assembly and the rigid frame. The fourth isolator is substantially opposite of the third isolator in relation to the circuit board assembly, wherein the fourth isolator is held in place by equal and opposite forces from the rigid frame and the circuit board.

### DRAWINGS

Understanding that the drawings depict only exemplary embodiments of the present invention and are not therefore to be considered limiting in scope, the exemplary embodiments will be described with additional specificity and detail through the use of the accompanying drawings, in which:
Figure 1 is an exploded view of one embodiment of a electronic device including means for isolating electronic components;
Figure 2 is a cross-sectional perspective view of the electronic device of Figure 1;
Figure 3A is a cross-sectional top view of the electronic device of Figure 1;
Figure 3B is a close-up view of the electronic device of Figure 3A;
Figure 4A is a cross-sectional side view of the electronic device of Figure 1;
Figure 4B is a cross-sectional perspective view of the electronic device of Figure 1;
Figure 5 is an exploded view of another embodiment of an electronic device including means for isolating electronic components;
Figure 6 is a side cross-sectional view of the electronic device of Figure 5; and
Figure 7 is a cross-section view of the electronic device of Figure 5.

In accordance with common practice, the various described features are not drawn to scale but are drawn to emphasize specific features relevant to the exemplary embodiments of the present invention.

### DETAILED DESCRIPTION

The present disclosure is directed towards an apparatus for isolating electronic components from vibration. The apparatus comprises a rigid outer frame housing a circuit board assembly. A plurality of isolators are located between the circuit board assembly and the frame to isolate the circuit board assembly from vibration in the frame and surrounding environment. The isolators are composed of an elastomer and are located on opposite sides of the circuit board assembly. The isolators are held between the circuit board assembly and the frame by equal and opposite forces on the isolators by the frame and circuit board assembly.

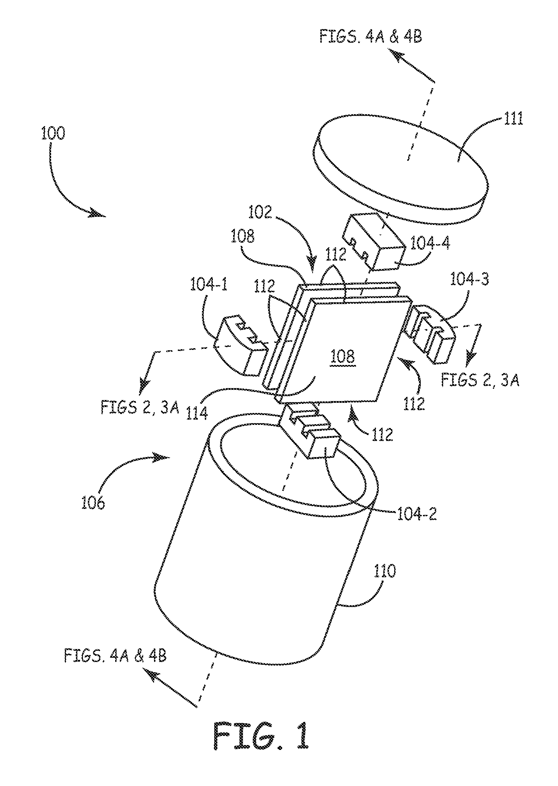

Figure 1 illustrates an exploded view of one embodiment of an electronic device 100 including a means of isolating electronic components from vibration. Electronic device 100 comprises a circuit board assembly 102, a plurality of isolators 104, and a frame 106. For explanation purposes, isolators 104 are labeled individually as isolator 104-1, 104-2, 104-3, and 104-4, and are referred to generally as "isolators 104".

Electronic device 100 isolates circuit board assembly 102 from external environmental vibration by dampening external vibration with isolators 104. Circuit board assembly 102 comprises a plurality of circuit boards 108, each circuit board 108 having four edges 112 and two faces 114. Each circuit board 108 comprises a plurality of electronic and/or mechanical components. For example, in one embodiment, circuit board assembly 102 comprises a gyroscope and associated electronics to obtain measurements from the gyroscope. Electronic device 100, therefore, comprises a gyroscope on circuit board assembly 102 mounted in frame 106. Electronic device 100 can be mounted in a desired location for taking measurements with the gyroscope by mounting frame 106 to another structure in the desired location. In one embodiment, the gyroscope is a micro-electro-mechanical system (MEMS) device and electronic device 100 is approximately 3.6 cm in diameter.

In this embodiment, frame 106 comprises a body 110 and a cover 111 and frame 106 is a hollow cylinder with a top and a bottom which houses circuit board assembly 102. Thus, in this embodiment, frame 106 surrounds circuit board assembly 102 in all three dimensions. Frame 106 is composed of a rigid material sufficient to support circuit board assembly 102 and isolators 104. Frame 106 also enables rigid connection between frame 106 and another structure (not shown). In one embodiment, frame 106 is composed of aluminum, however; in other embodiments, frame 106 is composed of other rigid materials such as steel or plastic.

Although as shown in Figure 1, frame 106 surrounds circuit board assembly 102 in three dimensions, in other embodiments, frame 106 is a ring, square, or other similar structure that encircles circuit board assembly 102 along two axes and is open along a third axis. Here, frame 106 still supports circuit board assembly 102 at the locations of isolators 104. Furthermore, in yet another embodiment, frame 106 substantially surrounds circuit board assembly 102 in three dimensions, except for an aperture in frame 106 for connection of an electronic cable or the like to circuit board assembly 106. Although in this embodiment, frame 106 is cylindrical in shape, in other embodiments other shapes are used including cube, rectilinear, and other simple or complex shapes.

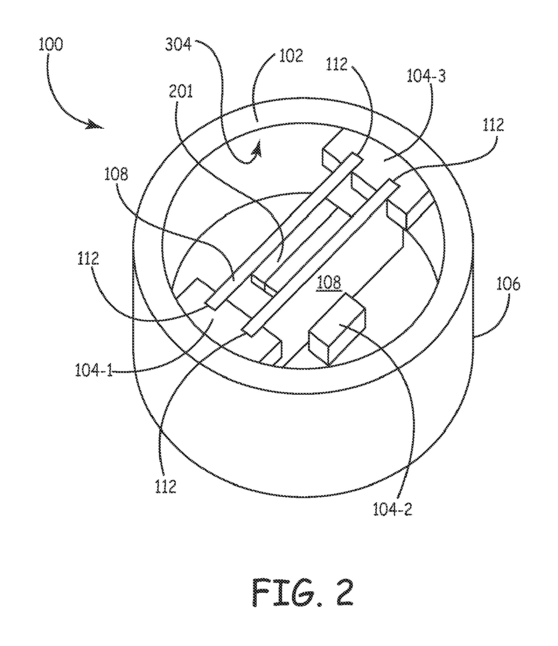

Figure 2 illustrates a cross-sectional perspective view of one embodiment of electronic device 100 with circuit board assembly 102 installed in frame 106. Each of the plurality of circuit boards 108 is positioned in parallel such that edges 112 of circuit boards 108 are generally flush with one another. Circuit board assembly 102 comprises two circuit boards 108 that are coupled together with an interconnect mechanism 201. In an alternative embodiment, circuit boards 108 are coupled together with flexible cabling. Although the embodiment illustrated herein comprises two circuit boards 108, in other embodiments, circuit board assembly 102 comprises more than two circuit boards 108. Additionally, although circuit boards 108 are shown as having a square shape, in other embodiments, circuit boards 108 have circular or other shapes.

Circuit boards 108 are composed of a substrate to mechanically support and electrically couple electronic components on circuit boards 108. As known to those skilled in the art, circuit boards 108 are rigid structures that are typically composed of silicon. Here, along with supporting electrical components, circuit boards 108 are used to structurally support the electronic components within frame 106.

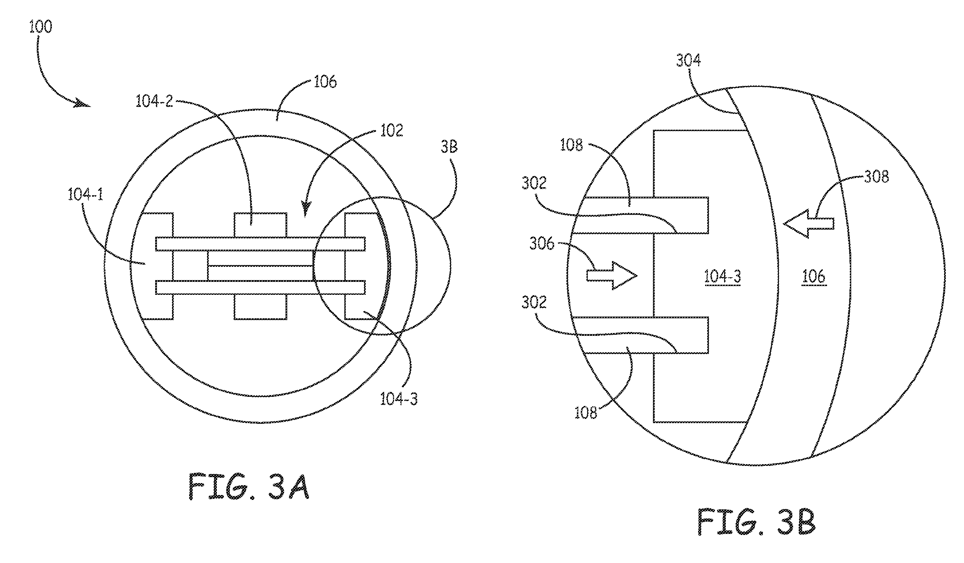

Isolators 104 are located between circuit board assembly 102 and frame 106. Specifically, isolators 104 are located between edges 112 of circuit board 108 and an inner surface 304 of frame 1-6. Isolators 104 are held in place between circuit board assembly 102 and frame 106 by equal and opposite force placed on isolators 104 by circuit board assembly 102 and frame 106 respectively. In other words, circuit board assembly 102 places a force on isolators 104 in a first direction and frame 106 places a force on isolators 104 equal to the force of circuit board assembly and in a direction opposite the first direction. These contradicting forces cancel out to suspend isolators 104 in place between circuit board assembly 102 and frame 106. Additionally, return forces from isolators 104 on circuit board assembly 102, suspend circuit board assembly 102 within frame 106. In the embodiment shown in Figure 2, isolators 104 are held in compression, such that circuit board assembly 102 places inward force (relative to the isolator 104) on isolator 104 and frame 106 also places inward force on the isolator 104. In an alternative embodiment, isolators 104 are held in tension, such that circuit board assembly 102 places outward force (relative to isolator 104) on isolator 104 and frame 106 also places outward force on isolator 104. The equal and opposite force holding isolators 104 in place is explained in more detail with respect to Figures 3-5 below.

Isolators 104 are located on edges 112 of circuit boards 108 such that the combined forces of isolators 104 hold circuit board assembly 102 in place. In other words, the forces placed by each isolator 104 on circuit board assembly 102 cancel each other out such that circuit board assembly 102 is held in place within frame 102. This is explained in more detail with respect to Figures 3-5. Forces are applied to isolators 104 by the rigid structure of frame 106 and the rigid structure of circuit board assembly 102.

Isolators 104 are composed of an elastomer material. In one embodiment, isolators 104 consist essentially of an elastomer material such that no metals or other materials are adhered or molded to isolators 104 to enable coupling between isolators 104 and frame 106, and isolators 104 and circuit board assembly 102.

Figure 3A is a top cross-sectional view of one embodiment of electronic device 100. As shown isolator 104-1 is located on one edge 112 of circuit boards 108 and isolator 104-3 is located on an opposite edge 112 of circuit boards 108. Positioning isolators 104-1, 104-3 on opposite edges 112 of circuit boards 108 enables equal and opposite forces to be placed on circuit board assembly 102 and on isolator 104-1 and isolator 104-3. This causes a friction fit of circuit board assembly 102 within frame 106 which holds circuit board assembly 102 and isolators 104-1 and 104-3 in place.

In the embodiment shown in Figure 3A, isolators 104-1, 104-3 are under compression while installed in frame 106. In equilibrium isolators 104-1, 104-3 are slightly larger than the space they fill between circuit board assembly 102 and frame 106. This increased size places isolators 104-1, 104-3 in compression when installed in frame 106. The compression causes isolators 104-1, 104-3 to be held in place between frame 106 and circuit board assembly 102 by equal and opposite forces. For example, the rigid structure of frame 106 places inward force on isolators 104-1, 104-3, while circuit board assembly 102 places outward forces on isolators 104-1, 104-3.

As shown in Figure 3A, isolator 104-2 is located on the bottom of circuit board assembly 102 and a matching isolator 104-4 (not shown in Figure 3A) is on the opposite side (top) of circuit board assembly 102. Similar to isolators 104-1, 104-3, isolators 104-2, 104-4 are held in place by equal and opposite forces.

In one embodiment, to install isolators 104 and circuit board assembly 102 in frame 106, isolators are compressed prior to installation. Here, isolators 104 are first installed on circuit board assembly 102. While on circuit board assembly 102 isolators 104 are compressed, and circuit board assembly 102 with isolators 104 thereon is placed in frame 106. Isolators 104 are then allowed to expand to contact and place force on frame 106. Circuit board assembly 102 is thus held in place within frame 106 by the friction caused by contact force between circuit board assembly 102 and isolators 104 and friction caused by contact force between isolators 104 and frame 106. Frame 106, therefore supports circuit board assembly 102 via the friction between frame 106 and isolators 104 and the friction between isolators 104 and circuit boards 108 of circuit board assembly 102.

In another embodiment, body 110 of frame 106 comprises two halves that are attached together to form body 110. Here, isolators 104 are installed on circuit board assembly 102 and the two halves of body 110 are placed around circuit board assembly 102 and isolators 104. The two halves of body 110 are then attached together to form body 110. Cover 111 is then placed on body 110 to complete frame 106.

In one embodiment an adhesive is placed between isolators 104 and circuit board assembly 102. The adhesive aids in holding isolators 104 in place during installation of circuit board assembly 102 and isolators 104 in frame 106. In another embodiment, an adhesive is placed between isolators 104 and frame 106 to aid the friction in holding isolators 104 to circuit board assembly 102.

Figure 3B is a close up view of isolator 104-3 on circuit board assembly 102 and installed in frame 106. As shown, isolator 104-3 is in compression and is held in place by equal and opposite forces from circuit board assembly 102 and frame 106. The rigid structure of circuit board assembly 102 places force on isolator 104-3 in the direction of arrow 306. Similarly, the rigid structure of frame 106 places an equal force on isolator 104-3 in the direction of arrow 308. The two forces compress isolator 104-3. The compression of isolator 104-3 causes isolator 104-3 to exert return forces against both circuit board assembly 102 and frame 106. The force on the contact surfaces between isolator 104-3 and circuit board assembly 102, and isolator 104-3 and frame 106, causes friction which holds isolator 104-3 in place.

Additionally, since circuit board assembly 102 is placed between isolators 104-1 and 104-3, the equal and opposite forces and friction caused by isolators 104-1 and 104-3 and frame 106 hold circuit board assembly 102 in place within frame 106.

Isolator 104-3 is shaped to generally match the contour of inside surface 304 of frame 106. Isolator 104-3 is also shaped to accept circuit board assembly 102. Thus, in one embodiment, isolator 104-3 defines two grooves 302, one for each circuit board 108 of circuit board assembly 102. Each of grooves 302 is slightly smaller than the width of the circuit board 108 when isolator 104 is in equilibrium. This enables isolator 104 to place force on circuit board 108 when installed thereon.

In an alternative embodiment, isolator 104-3 does not have grooves for circuit boards 108 and is not contoured to the internal shape of frame 106. Instead, isolator 104-3 has a generally rectangular shape in equilibrium and is forced into a general shape such as shown in Figure 3B by compression and pressure between circuit board assembly 102 and frame 106.

In one embodiment, the edges of isolators 104 that contact frame 106 and circuit board assembly 102 are drawn smooth. Smooth edges increase the amount of area of surface to surface contact between isolators 104, and circuit board assembly 102 and frame 106 respectively. The increased contact surface area increases the amount of friction and thus holds circuit board assembly 102 more securely in place.

In one embodiment, frame 106 comprises a plurality of features on inner surface 304 of frame 106 to aid isolators 104 in "grabbing" frame 106. In one embodiment, the plurality of features are depressions in inner surface 304, such as, for example, grooves or dimples. In another embodiment, the plurality of features are projections from inner surface 304, such as, for example, spikes or ridges. These features aid in securing circuit board assembly 102 from rotation and also aid isolators 104 in dampening rotational vibration.

In one embodiment, isolators 104 are formed by cutting a sheet of isolation material to the desired shape with, for example, a laser. In other embodiments, the isolation sheet is cut with a water jet, a die or other cutting techniques. In yet another embodiment, isolators 104 are formed in a mold.

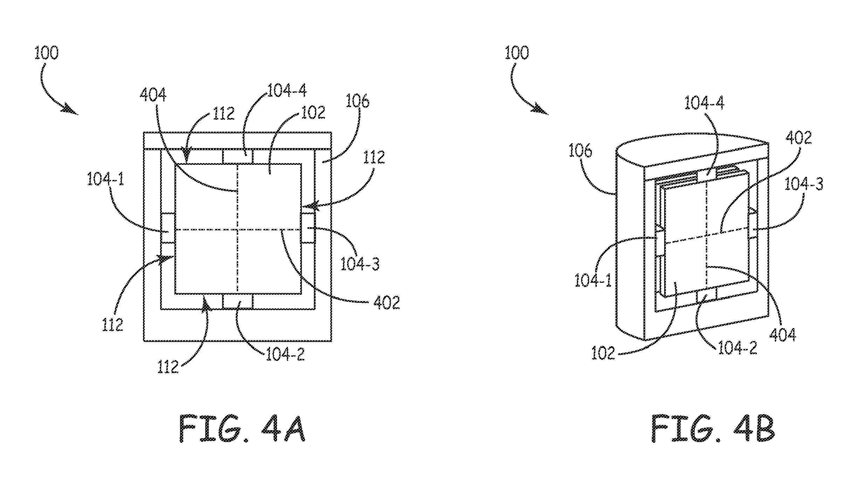

Figures 4A and 4B are cross-sectional views of electronic device 100. Figure 4A is a side cross-sectional view and Figure 4B is a perspective cross-sectional view. Each isolator 104-1, 104-2, 104-3, and 104-4 is located on one edge 112 of circuit boards 108 in circuit board assembly 102. Isolators 104-1, 104-2, 104-3, and 104-4 are located between circuit board assembly 102 and frame 106. In this way isolators 104-1, 104-2, 104-3, and 104-4 cause equal and opposite forces on circuit board assembly 102 which restrict movement of circuit board assembly 102 in directions parallel to the plane of circuit boards 108 in circuit board assembly 102. Isolators 104-1, 104-2, 104-3, and 104-4 also restrict circuit board assembly 102 from movement in directions perpendicular to the plane of circuit boards 108. The circular cross section (illustrated in Figure 3A) of frame 106 aids in restricting movement of circuit board assembly 102 in direction perpendicular to the plane of circuit boards 108.

Isolator 104-1 is located on a first edge 112 of circuit board assembly 102 and isolator 104-3 is located on a second edge 112 of circuit board assembly 102 opposite of isolator 104-1. Isolator 104-1 and 104-3 form an imaginary line across circuit board assembly 102, referred to herein as horizontal axis 402. Isolator 104-3 is located directly opposite of isolator 104-1 on circuit board assembly 102 which when combined with the rigid structure of circuit board assembly 102 places pressure on frame 106. Similarly, isolator 104-2 is on one side of circuit board assembly 102 and isolator 104-4 is on another side of circuit board assembly 102 opposite of isolator 104-2. Isolator 104-4 and 104-2 form an imaginary axis through circuit board assembly 102, referred to herein as vertical axis 404.

Isolators 104-1, 104-2, 104-3, and 104-4 are positioned such that horizontal axis 402 and vertical axis 404 cross approximately at the center of mass of circuit board assembly 102. The point at which horizontal axis 402 and vertical axis 404 cross is referred to herein as the center of isolation. Crossing at the center of mass of circuit board assembly 102 aids in reducing frequencies translated through isolators 104-1, 104-2, 104-3, and 104-4 to circuit board assembly 102. In this embodiment, the center of mass of circuit board assembly 102 is in the physical center of circuit board assembly 102. Thus, horizontal axis 402 and vertical axis 404 cross at the center of circuit board assembly 102, and isolators 104-1, 104-2, 104-3, and 104-4 are centered on each edge of circuit boards 108.

Isolators 104-1, 104-2, 104-3, and 104-4 isolate circuit board assembly 102 from vibration coupled to frame 106 from external sources by dampening the vibration. Isolators 104-1 and 104-3 primarily dampen incoming vibration in a vector parallel to horizontal axis 402. Similarly, isolators 104-2 and 104-4 primarily dampen incoming vibration in a vector parallel to vertical axis 404. Additionally, since each isolator 104-1, 104-2, 104-3, and 104-4 is friction fit between frame 106 and circuit board assembly 102, each isolator 104-1, 104-2, 104-3, and 104-4 also dampens vibration in an axis normal to the plane of circuit boards. Thus, isolators 104-1, 104-2, 104-3, and 104-4 provide 3 axes of isolation to circuit board assembly 102. As mentioned above, since isolators 104 provide isolation against rotational vibration as well as linear vibration isolators 104 provide 3 axes of rotation and linear isolation. Although in this embodiment, 3 axes of isolation are provided for both rotation and linear isolation, in other embodiments, either rotational or linear isolation may not provided or isolation may not be provided on all 3 axes.

Isolators 104-1, 104-2, 104-3, and 104-4 each exhibit a natural vibration frequency. At or near (just above or just below) the natural frequency, isolators 104-1, 104-2, 104-3, and 104-4 amplify vibration energy. For frequencies farther below the natural frequency, isolators 104-1, 104-2, 104-3, and 104-4 have minimal affect, providing little or no dampening and causing no amplification. For frequencies farther above the natural frequency, isolators 104-1, 104-2, 104-3, and 104-4 attenuate (dampen) the vibration energy.

The natural frequency for isolators 104-1, 104-2, 104-3, and 104-4 can be controlled based on the type of material isolators 104-1, 104-2, 104-3, and 104-4 are composed of, the amount of compression in which isolators 104-1, 104-2, 104-3, and 104-4 are placed under, and the amount of contact area between isolators 104-1, 104-2, 104-3, and 104-4 and frame 106. The stiffer the material used for isolators 104-1, 104-2, 104-3, and 104-4, the higher the natural frequency. Likewise, the more compression isolators 104-1, 104-2, 104-3, and 104-4 are put under the higher the natural frequency. Finally, the larger the contact area between isolators 104-1, 104-2, 104-3, and 104-4 and frame 106, the higher the natural frequency. Isolators 104-1, 104-2, 104-3, and 104-4, therefore, are configured in terms of size, compression, and contact area to achieve the desired dampening for a particular application.

In one embodiment, isolators 104-1, 104-2, 104-3, and 104-4 are configured to set their natural frequency at or below the environmental frequencies in which isolators 104-1, 104-2, 104-3, and 104-4 are to dampen. The mass of the device to be isolated (e.g. circuit board assembly 102) is also factored in to determine the natural frequency of isolators 104-1, 104-2, 104-3, and 104-4. For example, in one embodiment, electronic device 100 is in an environment that produces vibration frequency at 450Hz and higher. Here, isolators 104-1, 104-2, 104-3, and 104-4, given the mass of circuit board assembly 102, have their natural frequency set to 350Hz in order to attenuate frequencies of 450Hz and above.

As mentioned above, to control the natural frequency of isolators 104-1, 104-2, 104-3, and 104-4, the material, compression, and contact area are selected to meet the desired dampening criteria. For example, in one embodiment, isolators 104-1, 104-2, 104-3, and 104-4 are composed of an elastomer material having a durometer reading of 20. In addition to selection of material for a base durometer reading, material can be selected based on the performance of the material across a range of temperatures. Thus, for example, in one embodiment, the temperature range in which isolation is desired is -45 °C to 85 °C, and the material for isolator 104 is selected to such that the durometer reading varies only slightly over the desired temperature range. For example, in one embodiment isolators 104-1, 104-2, 104-3, and 104-4 are composed of 209E made by Barry Controls International.

Additionally, in one embodiment, isolators 104-1, 104-2, 104-3, and 104-4 are placed under compression in the range of 5-25%. To select the compression of each isolator 104-1, 104-2, 104-3, and 104-4, the size of each isolator 104-1, 104-2, 104-3, and 104-4 is selected prior to installation. The larger the size of isolator 104-1, 104-2, 104-3, and 104-4 in equilibrium compared to the installed size, the more compression the isolator 104-1, 104-2, 104-3, and 104-4 is under when installed. Finally, the size of isolators 104-1, 104-2, 104-3, and 104-4 is also selected to achieve the desired surface area of contact between isolators 104-1, 104-2, 104-3, and 104-4 and frame 106 as well as isolators 104-1, 104-2, 104-3, and 104-4 and circuit board assembly 102.

Although isolators 104 are shown and/or described as having a specific shape and size, in other embodiments, isolators 104 have other shapes and sizes of isolators 104 as desired for a particular implementation. For example, in an alternative embodiment, isolators 104 extend along each side and connect at corners of circuit board assembly 102 forming a ring around circuit board assembly. The ring is then compressed when installed in frame 106. Since the ring extends along all four sides of circuit boards 108 in circuit board assembly 102, the ring provides isolation to circuit board assembly 102 on 3-axes. Furthermore, although electronic device 100 is shown and described as having four isolators 104, other numbers of isolators may be used to achieve 3-axis isolation. For example, as mentioned above in one embodiment a single isolator 104 extends around all sides of circuit board assembly 102. In another embodiment, circuit boards 108 are triangular in shape and three isolators 104 are used, one isolator 104 on each side of circuit boards 108.

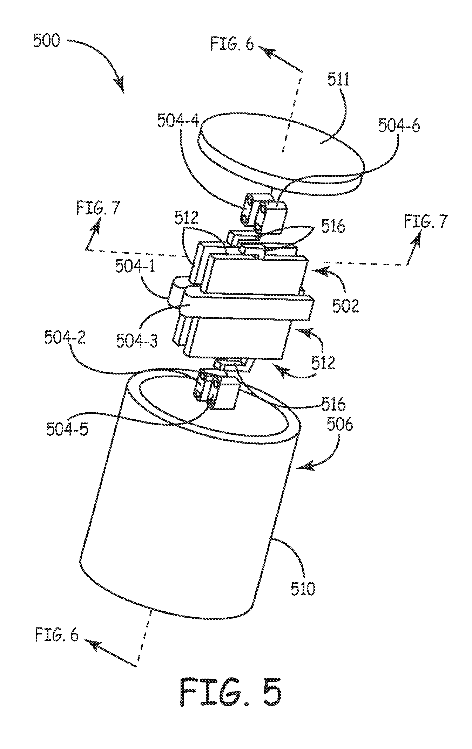

Figure 5 illustrates an exploded view of another embodiment of an electronic device 500 including a means of isolating electronic components from vibration. Electronic device 500 comprises a circuit board assembly 502, a plurality of isolators 504, and a frame 506. For explanation purposes, isolators 504 are labeled individually as isolator 504-1, 504-2, 504-3, and 504-4, 504-5, and 504-6, and are referred to generally as "isolators 504".

Electronic device 500 isolates circuit board assembly 502 from external environmental vibration by dampening the external vibration with isolators 504. Circuit board assembly 502 comprises a plurality of circuit boards 508, each circuit board having four edges 512 and two faces 514. Circuit board assembly 502 is generally similar to circuit board assembly 102, except that each circuit board 508 comprises a plurality of hooks 516. Hooks 516 enable connection of isolators 504-2, 504-4, 504-5, and 504-6 to circuit boards 508. In one embodiment, hooks 516 are machined portions of circuit boards 508.

Frame 506 is similar to frame 106 comprising a body 510 and a cover 511. Frame 506 is a hollow cylinder with a top and a bottom which houses circuit board assembly 502. Thus, in this embodiment, frame 506 surrounds circuit board assembly 502 in all three dimensions. Frame 506 is composed of a rigid material sufficient to support circuit board assembly 502 and isolators 504. Frame 506 also enables rigid connection between frame 506 and another structure (not shown). In one embodiment, frame 506 is composed of aluminum, however; in other embodiments, frame 506 is composed of other rigid materials such as steel or plastic.

Although as shown in Figure 5, frame 506 surrounds circuit board assembly 502 in three dimensions, in other embodiments, frame 506 is a ring, square, or other similar structure that encircles circuit board assembly 502 along two axes and is open along a third axis. Here, frame 506 still supports circuit board assembly 502 at the locations of isolators 504. Furthermore, in yet another embodiment, frame 506 substantially surrounds circuit board assembly 502 in three dimensions, except for an aperture in frame 506 for connection of an electronic cable or the like to circuit board assembly 506. Although in this embodiment, frame 506 is cylindrical in shape, in other embodiments other shapes are used including cube, rectilinear, and other simple or complex shapes.

In this embodiment, isolators 504-1, 504-3 extend around circuit boards 508 individually and couple to frame 106 on either side of circuit boards 508. Isolators 504-2, 504-4, 504-5, and 504-6 coupled between hooks 516 on circuit boards 508 and frame 106. Similar to isolators 104, isolators 504 are held in place by equal and opposite forces; however, isolators 504 are held in tension. Similarly, circuit board assembly 502 is held in place within frame 506 by equal and opposite forces placed on circuit board assembly 502 by isolators 504 from frame 506.

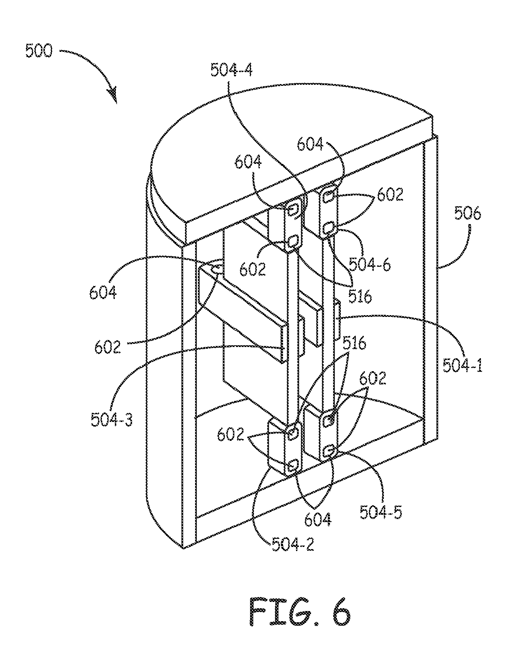

Figure 6 illustrates a side cross-sectional view of electronic device 500 with circuit board assembly 502 installed in frame 506. Isolators 504 are composed of an elastomer material. In one embodiment, isolators 504 consist essentially of an elastomer material such that no metals or other materials are used to provide structure to isolators 504 or to attach isolators 504 to frame 506. As shown, isolators 504-2, 504-5 are located on one edge 512 of circuit boards 508 and isolators 504-4, 504-6 are located on an opposite edge 512 of circuit boards 508. Positioning isolators 504-2, 504-5 on opposite edges 112 of circuit boards 508 relative to isolators 504-4, 504-6 enables equal and opposite forces to be placed on circuit board assembly 502 and on isolators 504-2, 504-4, 504-5, and 504-6.

Isolators 504 are held in tension between circuit board assembly 502 and frame 506 or between opposing sides of frame 506. Isolators 504-2, 504-4, 504-5, 504-6 are located between circuit board assembly 502 and frame 506. Isolators 504-2, 504-4, 504-5, 504-6 are coupled to circuit board assembly 502 with hooks 516. Hooks 516 are placed in apertures 602 defined in isolators 504-2, 504-4, 504-5, 504-6. Similarly, isolators 504-2, 504-4, 504-5, 504-6 are coupled to frame 106 with hooks 604. Hooks 604 are placed in apertures 602 defined in isolators 504-2, 504-4, 504-5, 504-6. To place isolators 504-2, 504-4, 504-5, 504-6 in tension, isolators are slightly smaller in equilibrium, than the space the fill when installed within electronic device 500. The decreased size places isolators 504-2, 504-4, 504-5, 504-6 in compression when installed. The tension causes isolators 504-2, 504-4, 504-5, 504-6 to be held in place by equal and opposite forces. For example, the rigid structure of frame 506 places outward force on isolators 504-2, 504-4, 504-5, 504-6, while circuit board assembly 502 places inward forces on isolators 504-2, 504-4, 504-5, 504-6.

Additionally, isolators 504-1, 504-3 coupled to hooks 604 on opposite sides of frame 506. Isolators 504-1, 504-3 extend around circuit boards 508 and coupled to hooks 604 on frame 506. Thus, isolators 504-1, 504-3 are stretched into tension between hooks 604 on frame 506. Isolators 504-1, 504-3 also hold circuit boards 508 in place via an aperture 606 that compresses against circuit boards 508. Aperture 606 is slightly smaller than the size of circuit boards 508 such that isolators 504-1, 504-3 hold circuit boards 508 when installed thereon.

In one embodiment, to install isolators 504 and circuit board assembly 502 in frame 506, isolators 504-1, 504-3 are installed on circuit boards 508 as shown in Figure 5. Circuit board assembly 502 with isolators 504-1, 504-3 thereon is placed in frame 506. Isolators 504-1, 504-3 are then stretched such that apertures 602 couple with hooks 604 on frame 506. Likewise, isolators 504-2, 504-4, 504-5, 504-6 are stretched to couple apertures 602 with hooks 604 on frame and hooks 516 on circuit boards 508. In another embodiment, frame 506 comprises two halves that are attached together to form frame 506.

In one embodiment, and adhesive is placed between apertures 606 in isolators 504 and circuit boards 508 to aid in holding circuit boards 508 in place within isolators 504. Additionally, in another embodiment, an adhesive is placed between apertures 602 and hooks 516, and hooks 604 respectively to aid in holding isolators 504 to hooks 516 and hooks 604.

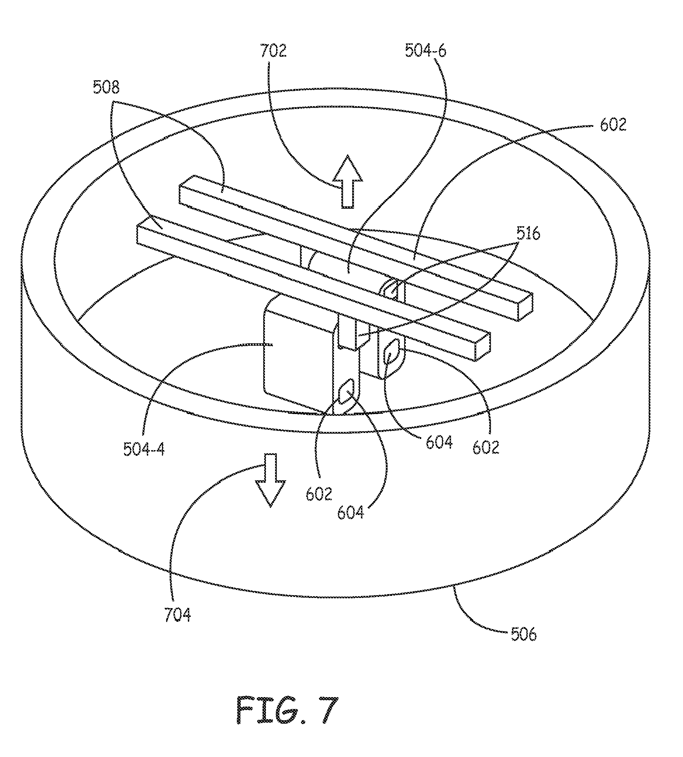

Figure 7 is a cross-sectional view of one embodiment of electronic device 500. As shown, isolators 504-4, 504-6 are in tension and are held in place by equal and opposite forces from circuit board assembly 502 and frame 506. The rigid structure of circuit board assembly 502 places force on isolators 504-4, 504-6 in the direction of arrow 702. Likewise, the rigid structure of frame 506 places an equal force on isolators 504-4, 504-6 in the direction of arrow 704. The two forces place isolators 504-4, 504-6 in tension. Additionally, circuit board assembly 502 is held in place by equal and opposite forces caused by isolators 504. In particular, the tension of isolators 504-4, 504-6 causes isolators to exert return forces against both circuit board assembly 102 and frame 106. The forces of isolators 504-4, 504-6 and the forces of isolators 504-2, 504-5 cancel each other out to hold circuit board assembly 502 in place within frame 506.

In one embodiment, similar to isolators 104, the location of isolators 504 around circuit board assembly 502 is selected to place the center of isolation of isolators 504 near the center of mass of circuit board assembly 502.

Isolators 504, therefore, provide 3 axes of isolation to circuit board assembly 102. Isolators 504 provide isolation against rotational vibration as well as linear vibration isolators 104, and thus provide 3 axes of rotation and linear isolation. Although in this embodiment, 3 axes of isolation are provided for both rotation and linear isolation, in other embodiments, either rotational or linear isolation may not provided or isolation may not be provided on all 3 axes.

Isolators 504 each exhibit a natural vibration frequency. At or near (just above or just below) the natural frequency, isolators 504 amplify vibration energy. For frequencies farther below the natural frequency, isolators 504 have minimal affect, providing little or no dampening and causing no amplification. For frequencies farther above the natural frequency, isolators 504 attenuate (dampen) the vibration energy.

The natural frequency for isolators 504 can be controlled based on the type of material isolators 504 are composed of, the amount of tension in which isolators 504 are placed under. The stiffer the material used for isolators 504, the higher the natural frequency. Likewise, the more tension isolators 504 are put under the higher the natural frequency. Finally, the amount of contact area between isolators 504 and frame 506 affects the natural frequency. Isolators 504, therefore, are configured in terms of size, tension, and contact area to achieve the desired dampening for a particular application.

In one embodiment, isolators 504 are configured to set their natural frequency at or below the environmental frequencies in which isolators 504 are to dampen. The mass of the device to be isolated (e.g. circuit board assembly 502) is also factored in to determine the natural frequency of isolators 504. For example, in one embodiment, electronic device 500 is in an environment that produces vibration frequency at 450Hz and higher. Here, isolators 504, given the mass of circuit board assembly 502, have their natural frequency set to 350Hz in order to attenuate frequencies of 450Hz and above.

As mentioned above, to control the natural frequency of isolators 504, the material, tension, and contact area are selected to meet the desired dampening criteria. For example, in one embodiment, isolators 504 are composed of an elastomer material having a durometer reading of 20. In addition to selection of material for a base durometer reading, material can be selected based on the performance of the material across a range of temperatures. Thus, for example, in one embodiment, the temperature range in which isolation is desired is -45 °C to 85 °C, and the material for isolators 504 is selected to such that the durometer reading varies only slightly over the desired temperature range. For example, in one embodiment isolators 504 are composed of 209E made by Barry Controls International.

Additionally, in one embodiment, isolators 504 are placed under tension in the range of 5-25%. To select the tension of each isolator 504, the size of each isolator 504 is selected prior to installation. The smaller the size of isolator 504 in equilibrium compared to the installed size, the more tension the isolator 504 is under when installed. Finally, the size of isolators 504 is also selected to achieve the desired area of contact between isolators 504 and frame 506 as well as isolators 504 and circuit board assembly 502.

Although isolators 504 are shown and/or described as having a specific shape and size, in other embodiments, isolators 504 have other shapes and sizes of isolators 504 as desired for a particular implementation. For example, in an alternative embodiment, isolators 504 extend along each side and connect at corners of circuit board assembly 504 forming a ring around circuit board assembly. The ring is then placed in tension by coupling to hooks when installed in frame 506. Since the ring extends along all four sides of circuit boards 508 in circuit board assembly 502, the ring provides isolation to circuit board assembly 502 on 3-axes. Furthermore, although electronic device 500 is shown and described as having six isolators 504, other numbers of isolators may be used to achieve 3-axis isolation. For example, as mentioned above in one embodiment a single isolator 504 extends around all sides of circuit board assembly 502. In another embodiment, circuit boards 508 are triangular in shape and three isolators 504 are used, one isolator 504 on each side of circuit boards 508.

Although the embodiments described above with reference to Figures 1 and Figures 5 respectively discuss either compression or tension isolators, in an alternative embodiment a combination of compression and tension isolators are used in a single embodiment. In other words, one or more isolators for isolating an electronic device are in compression and one or more other isolators for isolating the electronic device are in tension.

Although specific embodiments have been illustrated and described herein, it will be appreciated by those of ordinary skill in the art that any arrangement, which is calculated to achieve the same purpose, may be substituted for the specific embodiment shown. This disclosure is intended to cover any adaptations or variations of the inventions herein. Therefore, it is manifestly intended that the inventions herein be limited only by the claims and the equivalents thereof.

## Claims

1. An electronic device (100) comprising:
a frame (106);
a circuit board assembly (102) within the frame, the circuit board assembly comprising a plurality of circuit boards (108);
an elastomer material (104) between the circuit board assembly and the frame, wherein the elastomer material is held in place by equal and opposite forces.

2. The apparatus of claim 1, wherein the elastomer material is in compression between the circuit board assembly and the frame.

3. The apparatus of claim 2, wherein the elastomer material comprises a first isolator (104-1) on a first side of the circuit board assembly, a second isolator (104-2) on a second side of the circuit board assembly, a third isolator (104-3) on a third side of the circuit board assembly, and a fourth isolator (104-4) on a fourth side of the circuit board assembly.

4. The apparatus of claim 3, wherein a first axis defined by an imaginary line (402) across the circuit board assembly from the first isolator to the second isolator, and a second axis (404) is defined by an imaginary line across the circuit board assembly from the third isolator to the fourth isolator;
wherein the first, second, third, and fourth isolators are positioned such that the first axis and the second axis are substantially perpendicular.

5. The apparatus of claim 2, wherein the frame further comprises a plurality of features, wherein the first isolator is configured to contact the plurality of features.

6. The apparatus of claim 1, wherein the elastomer material is under tension between the circuit board assembly and the frame.

7. The apparatus of claim 6, wherein the elastomer material in under tension between opposing sides of the frame, and wherein the circuit board assembly is held within an aperture of the elastomer material.

8. An isolation system comprising:
a circuit board assembly (102) comprising:
a plurality of circuit boards (108), wherein the circuit boards are oriented to align in parallel; and
a micro-electrical-mechanical system (MEMS) device;
a plurality of isolators (104) composed of an elastomer material, wherein the plurality of isolators are located between the circuit board assembly and a rigid structure (106);
wherein the plurality of isolators are held in place between the plurality of circuit board assembly and the rigid structure by equal and opposite forces.

9. The isolation system of claim 8, wherein the isolators are under compression from forces of the circuit board assembly and the rigid structure.

10. The isolation system of claim 8, wherein the isolators are under tension from forces of the circuit board assembly and the rigid structure.
